# EUROPEAN PATENT APPLICATION

(11) **EP 4 822 721 A1**
(43) Date of publication of application: **14.10.2026**
(21) Application number: 26168764.4
(22) Date of filing: 27.03.2026
(51) Int. Cl.: H01F 7/18, F16K 31/06

(54) **DRIVING CIRCUIT FOR MASS FLOW CONTROLLERS**

(30) Priority: 09.04.2025 US 202563786054 P; 16.03.2026 US 202619567774
(71) Applicant: Illinois Tool Works Inc., Glenview IL 60025 (US)
(72) Inventor: KRAKHMAN, Vladimir, Glenview, 60025 (US)
(74) Representative: HGF

(57) **Abstract**

A disclosed example solenoid driving controller for a mass flow controller is provided. The solenoid driving circuit can include a switch voltage control circuit to receive power from a power supply and provide a predetermined voltage on the switch, and a solenoid current control circuit including a switch, or transistor, where a feedback signal from a current monitor aids in regulation of an constant output of a valve coil current based on the feedback signal.

## Description

### RELATED APPLICATIONS

The present application claims the benefit of U.S. Provisional Patent Application Serial No. 63/786,054, filed April 9, 2025, entitled "DRIVING CIRCUIT FOR MASS FLOW CONTROLLERS." The entirety of U.S. Provisional Patent Application Serial No. 63/786,054 is expressly incorporated herein by reference.

### FIELD OF THE DISCLOSURE

This disclosure is directed generally to solenoid driving circuits where power dissipation is critical and, more particularly, for a mass flow controller, the solenoid driving circuits adjusting flow in response to feedback signals.

### BACKGROUND

Mass flow controllers receive a flow of one or more gas/fluid, measure the amount of flow of the gas/fluid, and control the flow through a control valve.

### SUMMARY

Disclosed example mass flow controllers include solenoid driving circuits responsive to feedback signals, substantially as illustrated by and described in connection with at least one of the figures, as set forth more completely in the claims.

### BRIEF DESCRIPTION OF THE DRAWINGS

These and other features, aspects, and advantages of the present disclosure will become better understood when the following detailed description is read with reference to the accompanying drawings in which like characters represent like parts throughout the drawings, wherein:
FIG. 1 is a view of an example valve and mass flow controller, in accordance with aspects of this disclosure.
FIG. 2 illustrates an example of a solenoid driving circuit, in accordance with aspects of this disclosure.
FIG. 3 illustrates an example of a solenoid driving circuit for a mass flow controller, in accordance with aspects of this disclosure.
FIG. 4 illustrates another example of a solenoid driving circuit for a mass flow controller, in accordance with aspects of this disclosure.
FIG. 5 illustrates yet another example of a solenoid driving circuit for a mass flow controller, in accordance with aspects of this disclosure.
FIG. 6 illustrates yet another example of a solenoid driving circuit for a mass flow controller, in accordance with aspects of this disclosure.

The figures are not necessarily to scale. Wherever appropriate, similar or identical reference numerals are used to refer to similar or identical components.

### DETAILED DESCRIPTION

For the purpose of promoting an understanding of the principles of the claimed technology and presenting its currently understood, the best mode of operation, reference will be now made to the embodiments illustrated in the drawings and specific language will be used to describe the same. It will nevertheless be understood that no limitation of the scope of the claimed technology is thereby intended, with such alterations and further modifications in the illustrated device and such further applications of the principles of the claimed technology as illustrated therein being contemplated as would typically occur to one skilled in the art to which the claimed technology relates.

Mass flow controllers are used in applications such as semiconductor manufacturing, bioprocessing, thin film processing, and chemicals processing, to deliver precise ratios of fluids/gases. In the example of semiconductor manufacturing, gas can be precisely delivered to different regions of a wafer. Such manufacturing applications benefit from faster response times, repeatability of results, and consistency of results, in addition to cost-effectiveness. Conventional mass flow controllers include inlet pressure sensors and outlet pressure sensors, as well as mass flow control valves to control delivery of the fluid flow. Precision control of the valve can provide improved delivery of such fluids.

Some example solenoid driving circuits operate under constant current control circuits. Such circuits may include adjustable voltage sources, which power a valve coil. Current through the valve coil can be controlled by an operational amplifier. The current level can be set by a fixed reference voltage source, which is compared with a voltage drop across one or more resistors connected in series with the valve solenoid coil. One or more circuit components can cause adjustments from the voltage source, to keep both voltages at a desired level.

Thus, as disclosed herein, improved solenoid driving circuits for mass flow controllers are responsive to control circuits, as provided with respect to the representative figures.

In disclosed examples, a solenoid driving circuit for a mass flow controller, including a switch voltage control circuit including a first amplifier, the driving circuit to receive power from a power supply and provide a predetermined voltage on a switch, wherein the first amplifier regulates a voltage along the switch from the power supply based on a reference voltage; and a solenoid current control circuit including a switch, a second amplifier, and a current monitor, wherein the feedback circuit receives a feedback signal from the current monitor to regulate a constant current output to a coil to power movement of a solenoid plunger, based on the feedback signal.

In some examples, the circuit further includes a control circuit to provide commands the driving circuit.

In examples, the control circuit is external to the driving circuit.

In examples, the control circuit calculates the reference voltage to maintain a predetermined switch voltage as the current changes.

In examples, the predetermined switch voltage is a minimum voltage range.

In examples, the minimum voltage range is within tens of a millivolt or less.

In some examples, the switch is a metal-oxide-semiconductor field-effect transistor (MOSFET), wherein voltage across the MOSFET is adjusted in response to the current feedback signal.

In some examples, the voltage control reference voltage is provided by the control circuit or by the solenoid current feedback signal.

In some disclosed examples, a solenoid driving circuit for a mass flow controller including a switch voltage control circuit including a first amplifier, the driving circuit to receive power from a power supply and provide a predetermined voltage on the switch, wherein the first amplifier regulates a voltage along the switch from the power supply based on a reference voltage; and a solenoid current control circuit including a switch, a second amplifier, and a current monitor, wherein the feedback circuit receives a feedback signal from the current monitor to regulate a constant current output to a coil to power movement of a solenoid plunger, based on the feedback signal; and a summing device configured to calculate the switch voltage control circuit reference voltage in response to changes in current received through the current feedback signal.

In some examples, the circuit further includes a current sensing resistor configured to transmit a current value to set a value of the switch voltage control circuit reference voltage.

In examples, the summing device calculates the switch voltage control circuit reference voltage based on the current feedback signal from the current sensing resistor.

In some examples, the processed current feedback signal is mathematically processed amplified, or divided.

In some examples, the circuit further includes a current reference voltage configured to transmit a voltage value to set a value of the switch voltage control circuit reference voltage.

In examples, the summing device calculates the switch voltage control circuit reference voltage based on the current feedback signal from the current-to- voltage converter device.

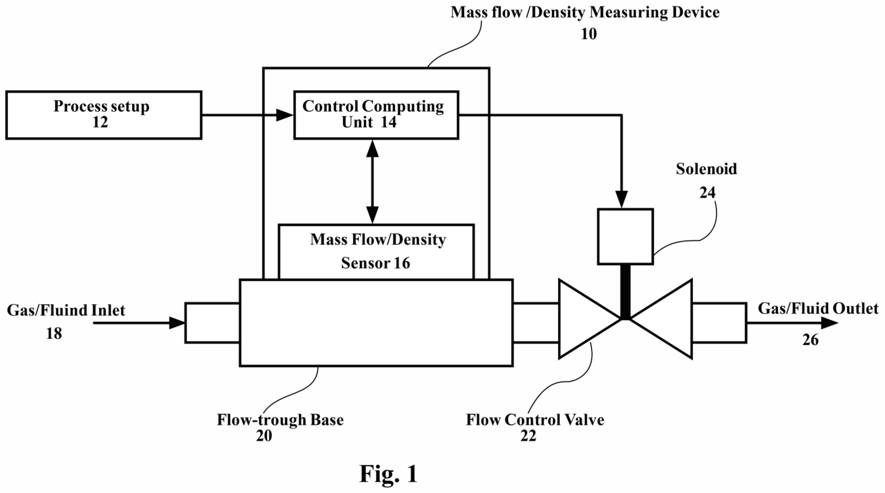

FIG. 1 is a view of an example mass flow and/or density measuring device 10 in which a solenoid valve mass flow controller is employed, in accordance with aspects of this disclosure. The illustrated mass flow measurement and control system 10 includes a process setup 12, a control or computing unit 14 (e.g., control circuitry), one or more sensors 16. The device 10 is connected to a flow through base 20 to channel a gas/fluid from an inlet 18 to a outlet 26. A flow control valve 22 is arranged between the inlet and the outlet, the flow valve controlled by a current through a solenoid 24 based on commands from the control unit 14.

Disclosed are solenoid driving circuits for mass flow controllers designed to provide improved accuracy and efficiency compared to conventional valve driving circuits. This solution can be used by any kind of mass flow controller, such as those employing thermal based sensors (e.g., sensors 16, at an inlet and/or an outlet of the fluid). In some designs, the valve solenoid 24 is a part of the controller and can be a source of power dissipation and thus heat.

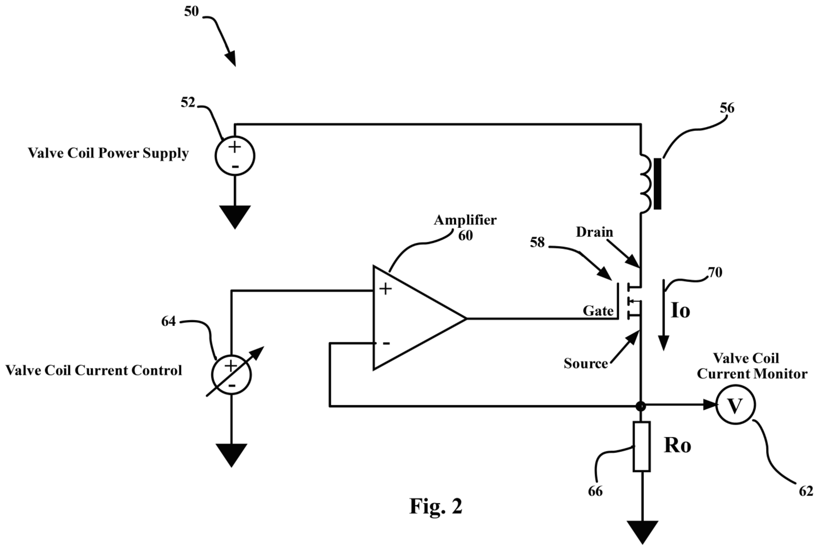

Accuracy of the kind of sensor described herein depends on the sensor temperature measurement, and is rather sensitive to ambient temperature, which can adversely affect accuracy of mass flow measurements. For instance, thermal sensors located inside enclosures housing the mass flow controller (and other power dissipated components inside of enclosure) contribute to internal temperature variations, which can have a direct impact on device performance. For example, sensitive parameters can include a temperature of the solenoid coil 24, and/or the temperature of the switch 58 (MOSFET) on FIG. 2. Maintaining the minimum temperature of each component, and the driving circuit generally, ensures minimal disruption due to power dissipation, as disclosed herein.

Thus, reducing total power dissipation (e.g., of one or more components inside of in the enclosure) helps to improve the thermal sensor measuring accuracy and leads to overall improved device performance. One contributor of power dissipation (and therefore temperature variations) is the valve coil driver circuitry. Decreasing solenoid coil driver power dissipation is one way to achieve better accuracy and improved efficiency of mass flow measurement and/or control. Decreasing solenoid coil driver power dissipation can also reduce overall power consumption of the entire device.

Disclosed example solenoid driving circuits for mass flow controllers provide improved accuracy compared with conventional mass flow controllers, as well as improved response times to changing flow rates. Some example precision gas/fluid distribution systems employing the solenoid drive circuits for the mass flow control further includes control circuitry. For example, the control circuitry configured to control the valve to regulate gas/fluid flow based on the measurements from temperature sensors that measure a temperature of the input process gas/fluid.

In some examples systems, solenoid 24 can include a plunger, surrounded by and responsive to an electrically activated coil. The coil is designed to move the plunger as the solenoid is energized and/or deenergized, although other suitable mechanisms for moving the plunger are considered within the scope of this disclosure. In operation, current to the coil can be controlled or adjusted, causing changes to a position of the plunger, and therefore control valve 22, relative to the flow channel. Control of the solenoid 24, the valve 22, and thus an amount of gas/fluid through the inlet 18, flow through base 20, and through the outlet 26, is driven by the solenoid driving circuit, as disclosed herein.

FIG. 2 illustrates an example of solenoid driving circuit 50. As shown, the circuit 50 includes a valve coil power supply 52 having a fixed output voltage, which is provided by internal feedback. Such a current control circuit responds to local feedback, including from operational amplifier 60, transistor 58 (e.g., a field-effect transistor (FET) or metal-oxide-semiconductor field-effect transistor (MOSFET) type transistor), and one or more current sense resistors 66. Variable parameters of valve solenoid 56 are not part of feedback circuits and have a reduced effect on the circuit's total stability.

A valve coil current control voltage source 64 is variable, and provides all necessary voltage range for valve coil control. Valve coil power supply 52 is fixed. In some examples, the circuit 50 experiences additional power dissipation on transistor 58, which can equal the product of voltage drop between a drain-to-source and/or valve current 70. Thus, when the valve is fully open, the current 70 (Io) can be significantly elevated, and power dissipation on the circuit is at a high level.

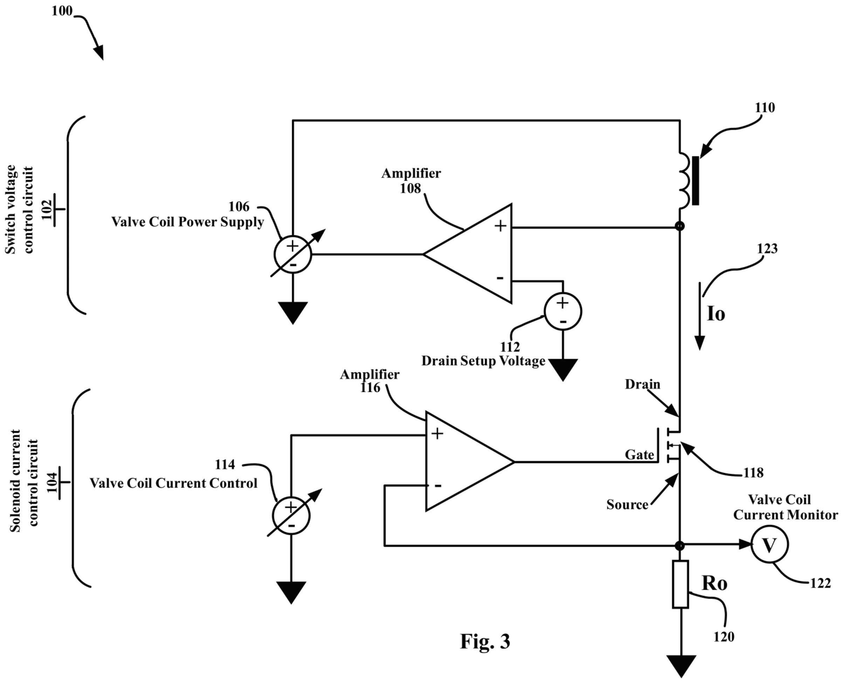

FIG. 3 illustrates an example solenoid driving circuit 100 for a mass flow controller, in accordance with aspects of this disclosure. As shown, the solenoid driving circuit 100 can include a switch voltage control circuit 102 including a first amplifier 108, the driving circuit 100 to receive power from a power supply 106 and provide a constant current output to a solenoid coil 110 to power movement of a plunger of solenoid. In some examples, the first amplifier 108 regulates a voltage at the drain of switch 118 (e.g., MOSFET), from the power supply 106 based on a reference voltage 112.

In the illustrated example, a solenoid current control circuit 104 including a switch 118, a second amplifier 116, and a current monitor 122. The solenoid current control circuit receives a feedback signal from the current monitor 122 to regulate an output from a valve coil current 123 based on the feedback signal.

As shown, the circuit 100 is configured to minimize power dissipation across switch 118. In operation, first operation amplifier 108 controls the variable valve coil power supply 106 the way that drain voltage stays fixed and equals to an output of a voltage reference 112. This voltage can be preset to provide a predetermined (e.g., minimum) drain-to-source voltage, such as under threshold (e.g., maximum) valve current 123 (Io). For example, for a switch 118 operating as an enhanced mode MOSFET transistor, the predetermined drain-to-source voltage can be within a given, set range (e.g., within tens of millivolts). The range ensures dissipation across switch 118 is low power. For this current source configuration, the valve coil is therefore a part of feedback circuit portion, and may cause a level of instability. However, as the voltage control range on drain of the switch 118 is relatively small, the stability of the circuit has a limited or insignificant impact on valve performance.

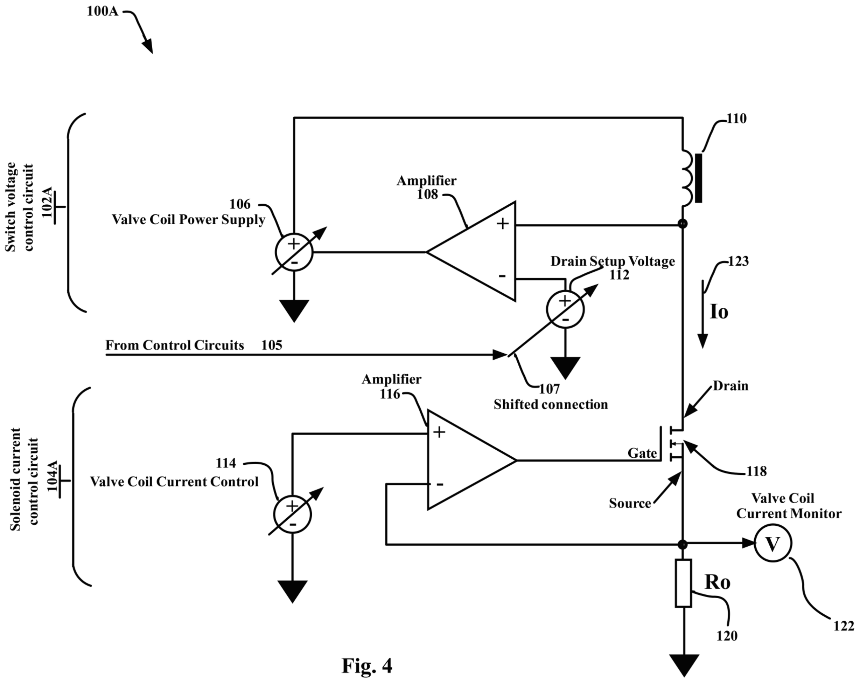

FIG. 4 illustrates another example solenoid driving circuit 100A for a mass flow controller, in accordance with aspects of this disclosure. Wherever appropriate, similar or identical reference numerals are used to refer to similar or identical components, such as appending a previously used reference numeral with an alphabetical designator to signify distinct components with similar functions, properties, structures, and/or arrangements.

As shown in FIG. 4, the solenoid driving circuit 100A includes a control circuit 105 to provide commands to the driving circuit. The control circuit 105 provides commands via one or more signals, controlling a switch reference voltage circuit at 112.

The control circuits 105 can be incorporated into the mass flow device (e.g., within control/computing unit 14 of device 10 shown in FIG. 1), and/or can be external to the device (e.g., at process setup 12 shown in FIG. 1, or remote from both the device and the process setup). In some examples, the control circuits 105 are embodied in an analog and/or digital computing device. The example control circuits 105 may be, for example, an integrated processing system, a programmable logic controller, a general-purpose computer, a laptop computer, a tablet computer, and/or any other type of processing system configured to communicate with the valve 22 on FIG. 1. For example, the control circuitry can include a processor, memory, and a storage device. The example processor may be any general purpose central processing unit (CPU) from any manufacturer. In some other examples, the processor may include one or more specialized processing units, such as RISC processors with an ARM core, graphic processing units, digital signal processors, and/or system-on-chips (SoC). The processor executes machine readable instructions that may be stored locally at the processor (e.g., in an included cache or SoC), in the memory (e.g., a random access memory or other volatile memory, a read only memory or other non-volatile memory such as FLASH memory, and/or in the storage device. The example storage device may be a hard drive, a solid state storage drive, a hybrid drive, a RAID array, and/or any other mass data storage device.

However, the disclosure is not so limited, allowing for the control circuits to be any type of processing and/or mathematical calculations/computational device suitable to provide fine control for a solenoid driving circuit.

In operation, the control circuit 105 is configured to calculate the reference voltage 112 and provide control in the form of shifted connection/signals 107 to amplifier 108 via reference voltage 112, in response to changes in current received through the current feedback signal.

For example, the control circuit 105 calculates the reference voltage 112 to maintain a predetermined switch voltage as the current changes. In disclosed examples, the predetermined switch voltage is a value within a voltage range (e.g., minimum) with the minimum voltage range being within tens of a millivolt.

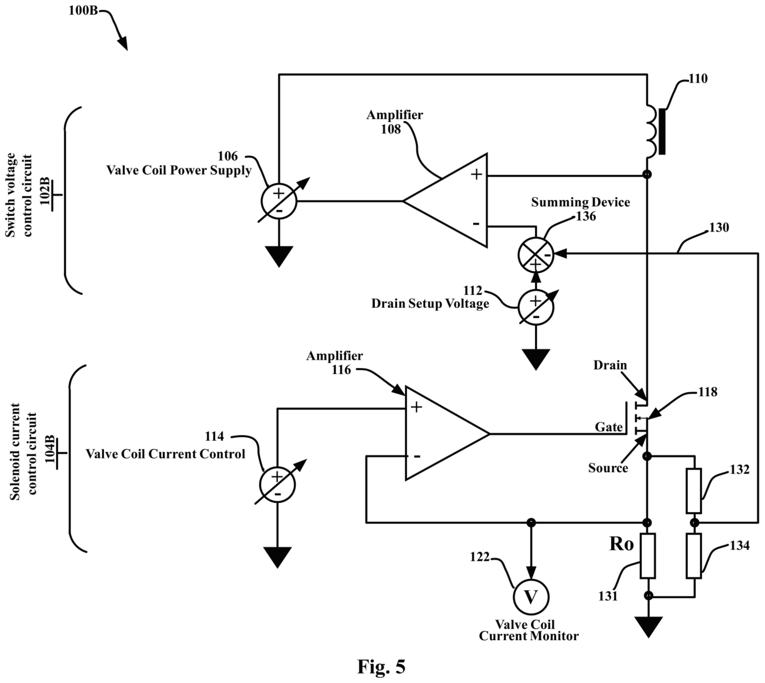

FIG. 5 the solenoid driving circuit 100B has similarities to the solenoid driving circuit 100A of FIG. 4, with the difference of drain setup voltage source 112 being adjustable by a signal derived from current feedback circuits at 131. The voltage is computed by one or more circuits in such a way that drain-to-source voltage is maintained at a predetermined (e.g., minimum) value, with current (Io) allowed to fluctuate across a range of variations.

Circuit 100B has similarities with circuit 100A, however, instead of computing drain-to-source voltage by the control circuit 105 (on FIG. 4), it is automatically generated by the current sense resistor 131. This voltage can be divided and/or subtracted from the drain set up voltage source 112 to minimize the drain-to-source voltage across switch 118. The greater the current, the greater the voltage being subtracted from the drain setup voltage source, thus maintaining a smaller drain-to-source voltage. This configuration reduces power dissipation across switch 118, even at high valve coil current levels.

In some examples, the circuit 100B is configured to generate the switch reference voltage based on either directly the current feedback signal or a processed current feedback signal (e.g., amplified, divided etc.) via amplifier 108. Thus, as provided in FIG. 4, voltage measurements can come directly from current monitor 122 (such as with digital control circuit), and/or could be made indirectly, using control circuitry (e.g., indirect analog, internal control). In this example, driving circuit 100B shown in FIG. 5, control of the solenoid is driven by a summing device 136, informed from a signal from voltage divider resistors 132 and/or 134. Thus, the reference voltage is calculated in response to changes in current received through the feedback signal 130.

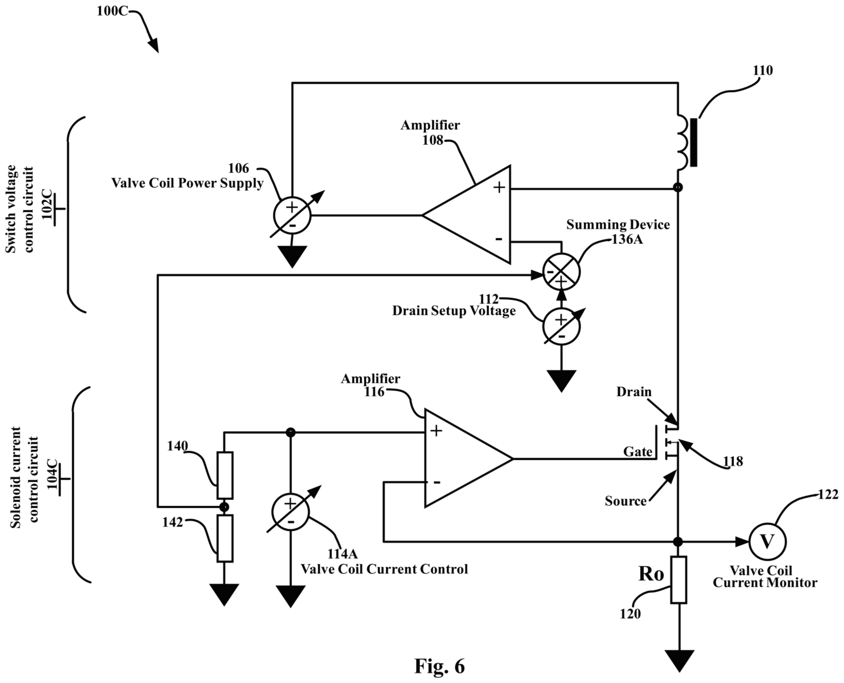

FIG. 6 illustrates yet another example solenoid driving circuit 100C for a mass flow controller, in accordance with aspects of this disclosure. In the example driving circuit 100C, control of the solenoid is driven by a summing device 136A, informed from a signal derived from the valve coil current control 114A by voltage divider resistors 140 and 142. The voltage divider resistors 140 and 142 are configured to transmit a voltage value to set a value of the switch 118. As shown in FIG. 6, an automatic compensation voltage is provided by the valve coil current control reference voltage supply 114A, which is similar to the voltage drop on the current sense resistor 120.

As utilized herein, "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z". As utilized herein, the term "exemplary" means serving as a non-limiting example, instance, or illustration. As utilized herein, the terms "e.g.," and "for example" set off lists of one or more non-limiting examples, instances, or illustrations.

While the present method and/or system has been described with reference to certain implementations, it will be understood by those skilled in the art that various changes may be made, and equivalents may be substituted without departing from the scope of the present method and/or system. For example, block and/or components of disclosed examples may be combined, divided, re-arranged, and/or otherwise modified. In addition, many modifications may be made to adapt a particular situation or material to the teachings of the present disclosure without departing from its scope. Therefore, the present method and/or system are not limited to the particular implementations disclosed. Instead, the present method and/or system will include all implementations falling within the scope of the appended claims, both literally and under the doctrine of equivalents.

## Claims

1. A solenoid driving circuit for a mass flow controller, comprising:
a switch voltage control circuit including a first amplifier, the driving circuit to receive power from a power supply and provide a predetermined voltage on a switch, wherein the first amplifier regulates a voltage along the switch from the power supply based on a reference voltage; and
a solenoid current control circuit including a switch, a second amplifier, and a current monitor, wherein the feedback circuit receives a feedback signal from the current monitor to regulate a constant current output to a coil to power movement of a solenoid plunger, based on the feedback signal.

2. The circuit of claim 1, further comprising a control circuit to provide commands the driving circuit.

3. The circuit of claim 2, wherein the control circuit is external to the driving circuit.

4. The circuit of claim 3, wherein the control circuit calculates the reference voltage to maintain a predetermined switch voltage as the current changes.

5. The circuit of claim 4, wherein the predetermined switch voltage is a minimum voltage range.

6. The circuit of claim 5, wherein the minimum voltage range is within tens of a millivolt or less.

7. The circuit of claim 1, wherein the switch is a metal-oxide-semiconductor field-effect transistor (MOSFET), wherein voltage across the MOSFET is adjusted in response to the current feedback signal.

8. The circuit of claim 1, wherein the voltage control reference voltage is provided by the control circuit or by the solenoid current feedback signal.

9. A solenoid driving circuit for a mass flow controller, comprising:
a switch voltage control circuit including a first amplifier, the driving circuit to receive power from a power supply and provide a predetermined voltage on the switch, wherein the first amplifier regulates a voltage along the switch from the power supply based on a reference voltage; and
a solenoid current control circuit including a switch, a second amplifier, and a current monitor, wherein the feedback circuit receives a feedback signal from the current monitor to regulate a constant current output to a coil to power movement of a solenoid plunger, based on the feedback signal; and
a summing device configured to calculate the switch voltage control circuit reference voltage in response to changes in current received through the current feedback signal.

10. The circuit of claim 9, further comprising a current sensing resistor configured to transmit a current value to set a value of the switch voltage control circuit reference voltage.

11. The circuit of claim 9, wherein the summing device calculates the switch voltage control circuit reference voltage based on the current feedback signal from the current sensing resistor.

12. The circuit of claim 11, wherein the processed current feedback signal is mathematically processed amplified, or divided.

13. The circuit of claim 9, further comprising a current reference voltage configured to transmit a voltage value to set a value of the switch voltage control circuit reference voltage.

14. The circuit of claim 9, wherein the summing device calculates the switch voltage control circuit reference voltage based on the current feedback signal from the current-to-voltage converter device.
